# EUROPEAN PATENT APPLICATION

(11) **EP 1 732 111 A1**
(43) Date of publication of application: **13.12.2006**
(21) Application number: 05721602.0
(22) Date of filing: 28.03.2005
(51) Int. Cl.: H01L 21/205, C23C 16/458, H01L 21/68

(54) **SUSCEPTOR**

(30) Priority: 31.03.2004 JP 2004106950
(71) Applicant: TOYO TANSO CO., LTD., Osaka-shi, Osaka 555-0011 (JP)
(72) Inventor: Kimoto, Tunenobu, Fushimi-ku, Kyoto-shi, Kyoto 6128031 (JP); MATSUNAMI, Hiroyuki, 6148351 (JP); Fujiwara, Hirokazu, Mitoyo-gun, Kagawa 7691612 (JP)
(74) Representative: TBK-Patent
(86) International application number: PCT/JP2005/005675
(87) International publication number: WO 2005/096356

(57) **Abstract**

A susceptor that is used in semiconductor epitaxial growth and can simultaneously obtain a plurality of epitaxial films high in the uniformity is provided.

A susceptor according to the invention is a susceptor that is used in semiconductor epitaxial growth and includes a barrel type susceptor having a plurality of surfaces on an outer side of each of which a plurality of substrates can be freely disposed; and a member that has the barrel type susceptor disposed inside thereof and surfaces each of which is oppositely disposed tilting in the same direction as each of the surfaces of the barrel type susceptor. Alternatively, a susceptor according to the invention includes a barrel type susceptor having a plurality of surfaces on an inner side of each of which a plurality of substrates can be freely disposed; and a member that has the barrel type susceptor disposed at the peripheral portion thereof and surfaces each of which is oppositely disposed tilting in the same direction as each of the surfaces of the barrel type susceptor.

## Description

### Technical Field

The present invention relates to a susceptor that is used to epitaxially grow compound semiconductors such as silicon carbide, gallium nitride and aluminum nitride, in particular, a susceptor that allows obtaining a uniform epitaxial growth film (hereinafter, referred to as an epitaxial film) on each of a plurality of substrates.

### Background Art

So far, in a semiconductor manufacturing process, a single crystal growth method where, by use of a chemical vapor deposition method (CVD method), raw material gases are reacted in a gaseous phase to grow an epitaxial layer on a wafer is carried out. Specifically, in the CVD method, a single crystal wafer is placed on a susceptor, and the susceptor and wafer are heated to an epitaxial growth temperature and held there. Subsequently, a mixture gas of a carrier gas and raw material gases is introduced in a reaction furnace and raw material gases decomposed by heating to a high temperature were deposited on the wafer to form an epitaxial layer. As a reaction furnace that grows a thick epitaxial layer at high speed, a vertical gas phase growth unit where the gas is flowed in an up and down direction is frequently used (patent literatures 1 and 2).
Patent literature 1: JP-A-11-176757
Patent literature 2: JP-B-5-87128

### Disclosure of the Invention

### Problems that the Invention is to Solve

However, in an existing reaction furnace, since distances between a plurality of substrates on the susceptor and a wall surface facing the substrates are largely different, temperature difference is likely to occur between the respective substrates. Accordingly, since an epitaxial growth speed is different between the substrates to result in different thicknesses of epitaxial films, it is difficult to simultaneously obtain a plurality of epitaxial films of equal quality.

There, the invention intends to provide a susceptor that is used in semiconductor epitaxial growth and allows simultaneously obtaining a plurality of epitaxial films high in the uniformity.

### Means for Solving the Problems and Advantage of the Invention

The invention relates to a susceptor that is used in semiconductor epitaxial growth and the susceptor includes a barrel type susceptor having a plurality of surfaces on an outer side of each of which a plurality of substrates can be freely disposed; and a member that has the barrel type susceptor disposed inside thereof and surfaces of each of which is oppositely disposed tilting in the same direction as each of the surfaces of the barrel type susceptor.
Owing to the configuration, when the susceptor according to the invention is applied to a semiconductor epitaxial growth process, temperatures of the respective substrates can be made uniform, and thereby a plurality of epitaxial films high in the uniformity can be simultaneously obtained.

The invention relates to a susceptor that is used in semiconductor epitaxial growth and the susceptor includes a barrel type susceptor having a plurality of surfaces on an inner side of each of which a plurality of substrates can be freely disposed; and a member that has the barrel type susceptor disposed at the peripheral portion thereof and surfaces each of which is oppositely disposed tilting in the same direction as each of the surfaces of the barrel type susceptor.
Owing to the configuration, when the susceptor according to the invention is applied to a semiconductor epitaxial growth process, temperatures of the respective substrates can be made uniform, and thereby a plurality of epitaxial films high in the uniformity can be simultaneously obtained.

In the susceptor according to the invention, on each of surfaces on a side of the barrel type susceptor of the member, a plurality of substrates is preferably freely disposed.
Owing to the configuration, further more epitaxial films high in the uniformity can be simultaneously obtained.

In the susceptor according to the invention, the barrel type susceptor and/or the member are preferably a heater.
Owing to the configuration, the respective substrates can be directly heated so as to be constant in the temperature; accordingly, more assuredly, a plurality of epitaxial films high in the uniformity can be simultaneously obtained.

The susceptor according to the invention is preferably made of a base material containing graphite. Furthermore, the susceptor according to the invention is preferably covered with polycrystalline silicon carbide or polycrystalline tantalum carbide.
When the semiconductor epitaxial growth is carried out with a heating method that uses a high-frequency coil, the susceptor itself can be made a heating source; accordingly, the respective substrates can be directly heated so as to be constant in the temperature. As a result, more assuredly, a plurality of epitaxial films high in the uniformity can be simultaneously obtained. Furthermore, when the susceptor is covered with polycrystalline silicon carbide or polycrystalline tantalum carbide, an impurity contained in the susceptor made of graphite can be inhibited from being emitted. In particular, when the susceptor is covered with polycrystalline tantalum carbide, since the tantalum carbide is a material that is excellent in the high temperature characteristics and excellent as well in the corrosion resistance to hydrogen, a coating material can be inhibited from sublimating and graphite can be inhibited from being exposed, and thereby the impurity can be inhibited from being emitted.

### Best Mode for Carrying Out the Invention

In what follows, embodiments according to the invention will be described with reference to the drawings.

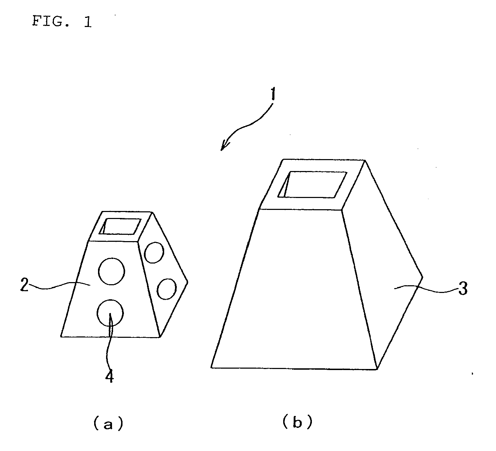

Fig. 1 is a perspective view separately showing constituent articles of a susceptor involving a first embodiment of the invention, (a) showing a barrel type internal susceptor, and (b) showing an external member.

A susceptor 1 shown in Fig. 1 includes an internal susceptor 2 with graphite as a base material and an external member 3 with graphite as a base material. Surfaces thereof are preferably covered with polycrystalline silicon carbide or polycrystalline tantalum carbide.
In the internal susceptor 2, four trapezoidal planes (all four trapezoidal planes have the same area) each having two concave counter boring portions 4 are tilted to a perpendicular at a predetermined angle and hypotenuses thereof are bonded each other, and thereby a barrel type susceptor is formed.
The external member 3 has a substantially similar shape as the internal susceptor 2 and allows disposing the internal susceptor 2 inside thereof. Furthermore, the external member 3 has four trapezoidal planes (all four trapezoidal planes have the same area) that, when the internal susceptor 2 is disposed inside thereof, can be oppositely disposed in parallel or in substantially parallel to the trapezoidal planes having counter boring portions 4 of the internal susceptor 2. That is, each of the trapezoidal planes of the external member 3 is tilted to a perpendicular at a predetermined angle.

A tilt angle of each of the trapezoidal planes of the internal susceptor 2 is, to a perpendicular direction, preferably in the range of 2 to 45° and a tilt angle of each of the trapezoidal planes of the external member 3 is, to a perpendicular direction, preferably in the range of 2 to 45°. When these are oppositely disposed in substantially parallel, a flow path on an inlet side of a gas is preferably wide and a flow path on an outlet side is preferably narrow. This can be achieved for instance when a tilt angle of the trapezoidal planes of the internal susceptor 2 is set at 12° to a perpendicular direction and a tilt angle of the trapezoidal planes of the external member 3 is set at 8° to a perpendicular direction. This is because with such a configuration heating of a gas can be appropriately suppressed. Furthermore, a distance between planes of the internal susceptor 2 and the external member 3 is in the range of 5 to 60 mm and desirably in the range of 10 to 25 mm.
Furthermore, the counter boring portion 4 may be disposed at least one. Still furthermore, the number of the trapezoidal planes of the internal susceptor 2 and the external member 3, without restricting to four, may be three or more, respectively.

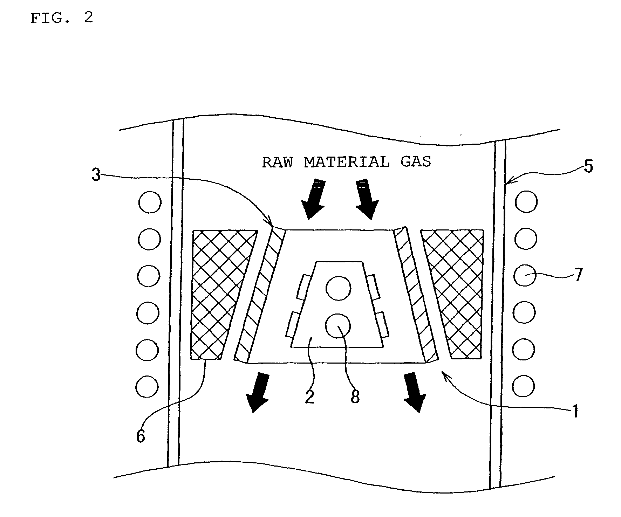

In the next place, an epitaxial growth unit that uses a susceptor according to a first embodiment will be described. Fig. 2 is a schematic view showing the neighborhood of a reaction chamber of the epitaxial growth unit that uses a susceptor shown in Fig. 1.

Inside of a reaction chamber 5 of the epitaxial growth unit shown in Fig. 2, a susceptor 1 according to the first embodiment is disposed at a center portion of the reaction chamber 5 and a heat insulating material 6 is disposed along an outer periphery portion of the susceptor 1. At an external periphery portion of the reaction chamber 5, a high frequency coil 7 is spirally disposed.

The susceptor 1 has a disposition configuration where, a direction of the external member of Fig. 1(b) is disposed upside down and inside thereof the susceptor according to Fig. 1(a) is disposed covered therewith. Trapezoidal planes of the internal susceptor 2 and trapezoidal planes of the external member 3 are disposed adjusted so as to be in parallel or substantially parallel.
The heat insulating material 6 is disposed between an inner wall of the reaction chamber 5 and the external periphery of the susceptor 1 to inhibit the heat from being released.
The high frequency coil 7 applies a high frequency to the susceptor 1 made of graphite to allow the susceptor 1 generating heat.

Next, epitaxial growth by use of the susceptor according to the first embodiment will be described with reference to Fig. 2.
In the beginning, on the internal susceptor 2 of the susceptor 1, substrates 8 are placed to carry out epitaxial growth. In the next place, the internal susceptor 2 is disposed at a position shown in Fig. 2 and the high frequency coil 7 is operated to heat the susceptor to a temperature appropriate to carry out the epitaxial growth. Then, a reaction gas is supplied flowing between the internal susceptor 2 of the susceptor 1 and the external member 3 thereof (arrow marks in Fig. 2).

According to the configuration, since the susceptor according to the first embodiment is employed in a semiconductor epitaxial growth process, the respective substrate temperatures can be made constant and a plurality of epitaxial films high in the uniformity can be simultaneously obtained. Furthermore, when polycrystalline silicon carbide or polycrystalline tantalum carbide is used to cover, impurities contained in the susceptor made of graphite can be inhibited from being emitted. In particular, when the polycrystalline tantalum carbide is used to cover, since the tantalum carbide is a material that is excellent in the high temperature characteristics and excellent as well in the corrosion resistance to hydrogen, a coating material can be inhibited from sublimating and graphite can be inhibited from being exposed, and thereby the impurity can be inhibited from being emitted.

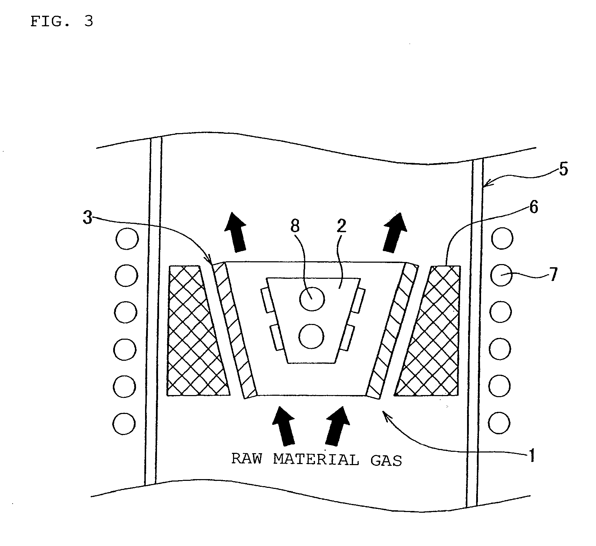

As a modification example of the embodiment, the internal susceptor 2 and/or external member 3 may be used as a heater.
Furthermore, as a modification example of an arrangement inside of the reaction chamber 5, as shown in Fig. 3, the susceptor 1 and heat insulating material 6 of Fig. 2 may be disposed upside down. At this time, a reaction gas is flowed from bottom up (arrow marks in Fig. 3).

In the next place, a susceptor according to a second embodiment of the invention will be described.

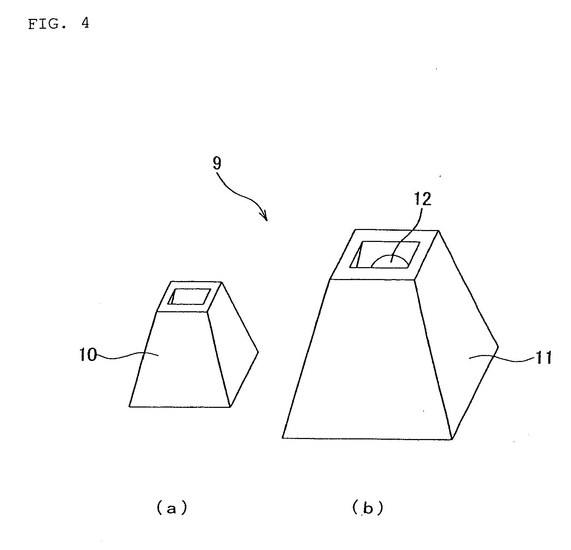

Fig. 4 is a perspective view separately showing constituent articles of a susceptor involving a second embodiment of the invention, (a) showing an internal member, and (b) showing a barrel type external susceptor.

A susceptor 9 shown in Fig. 2 includes an internal member 10 with graphite as a base material and an external susceptor 11 with graphite as a base material. Surfaces thereof are preferably covered with polycrystalline silicon carbide or polycrystalline tantalum carbide.
In the external susceptor 11, four trapezoidal planes (all four trapezoidal planes have the same area) each having a counter boring portion 12 are tilted to a perpendicular at a predetermined angle and hypotenuses thereof are bonded each other, and thereby the external susceptor 11 is formed.
The internal member 10 has a substantially similar shape as the external susceptor 11 and can be disposed inside the external susceptor 11. Furthermore, the internal member 10 has four trapezoidal planes (all four trapezoidal planes have the same area), each of which, when the internal member 10 is disposed inside the external susceptor 11, can be oppositely disposed in parallel or in substantially parallel to each of the trapezoidal planes having a counter boring portion 12 of the external susceptor 11. That is, each of the trapezoidal planes of the internal member 10 is tilted to a perpendicular at a predetermined angle.

A tilt angle of each of the trapezoidal planes of the internal member 10 is, to a perpendicular direction, preferably in the range of 2 to 45° and a tilt angle of each of the trapezoidal planes of the external susceptor 11 is, to a perpendicular direction, preferably in the range of 2 to 45°. When these are oppositely disposed in substantially parallel, a flow path on an inlet side of a gas is preferably made wide and a flow path on an outlet side is preferably made narrow. This can be achieved for instance when a tilt angle of the trapezoidal planes of the internal susceptor 2 is set at 12° to a perpendicular direction and a tilt angle of the trapezoidal planes of the external member 3 is set at 8° to a perpendicular direction. This is because with such a configuration heating of a gas can be appropriately suppressed. Furthermore, a distance between planes of the internal susceptor 2 and the external member 3 is in the range of 5 to 60 mm and desirably in the range of 10 to 25 mm.
Furthermore, the counter boring portion 12 may be disposed at least one. Still furthermore, the number of the trapezoidal planes of the internal susceptor 2 and the external member 3, without restricting to four, may be three or more, respectively.

The susceptor 9 involving the embodiment can be applied in place of the susceptor 1 inside of the reaction chamber 5 of the epitaxial growth unit in Fig. 2. Thereby, advantages similar to that of the first embodiment can be obtained. Furthermore, as a modification example of the embodiment, the internal member 10 and/or external susceptor 11 may be used as a heater.

Furthermore, as a modification example of the first and second embodiments, a susceptor 13 where the internal susceptor 2 of Fig. 1 and the external susceptor 11 of Fig. 2 are applied may be constituted. The susceptor 13 can be applied in place of the susceptor 1 inside of the reaction chamber 5 of the epitaxial growth unit in Fig. 2.

Still furthermore, when a substrate is placed in a gravity-defying direction, a pin may be used to inhibit from falling.

### Example

An example of formation of an epitaxial layer by use of a barrel type gas phase reactor that, in place of a four-plane barrel type susceptor 1 of Fig. 1, uses a six-plane barrel type susceptor (not shown in the drawing) will be shown. Here, formation of an epitaxial layer of silicon carbide that is one of compound semiconductors will be described.

With a single crystal silicon carbide wafer having a diameter of 2 inch disposed in each of counter boring portions disposed on an internal surface of a six-plane barrel type susceptor, the susceptor was disposed at a predetermined place. The inside of a reaction chamber was replaced with H₂ gas, followed by evacuating to 5 × 10⁻⁶ Torr. After evacuation, H₂ gas that is a carrier gas and Ar gas that is an inert gas, respectively, were introduced from a raw material gas feed port (not shown in the drawing) and an inert gas feed port (not shown in the drawing) to maintain the inside of the reaction chamber at 100 Torr. The H₂ gas and Ar gas were continuously exhausted from an exhaust port (not shown in the drawing) and pressure inside of the reaction chamber is controlled with a pressure control valve (not shown in the drawing) disposed downstream of the exhaust port.

A spiral high frequency induction coil 7 was turned on to heat the susceptor to 1350°C. At that time, as a temperature inside of a furnace, a temperature on a wafer was measured with a radiation thermometer. From 1350°C and upward, a slight amount of raw material gas was introduced from a feed port (not shown in the drawing) to suppress the silicon carbide wafer from damaging caused by the H₂ etching. In this case, as the raw material gas, SiH₄ and C₃H₈ were used. Since the susceptor was used as a heating source and a heat insulating material was disposed, not only the heating efficiency was very good and thereby the power consumption could be saved, but also since a speedy temperature rise could be attained the damage owing to the H₂ etching during temperature rise of the wafer could be suppressed. As a result, high quality epitaxial layers could be obtained.

Furthermore, the susceptor and wafer were heated to 1835°C that is high as an epitaxial growth temperature, followed by maintaining a temperature inside of the furnace constant. Since the wafer was directly heated with the susceptor as a heating source and the heat insulating material was disposed, the heating efficiency was largely improved; accordingly, a speedy temperature rise and epitaxial growth under high temperatures could be realized. At that time, a flow rate of SiH₄ and that of C₃H₈, respectively, were increased to 120 sccm and 30 sccm, N₂ gas that is a doping gas was supplied at 0.05 sccm, and thereby the formation of the epitaxial layer was began. As the growth conditions of a silicon carbide epitaxial layer, a growth temperature of 1835°C, growth pressure of 100 Torr, a C/Si ratio of 0.75, a SiH₄/H₂ ratio of 0.4% by mole, a C₃H₈/H₂ ratio of 0.1% by mole and a growth time of 4 hr were adopted.

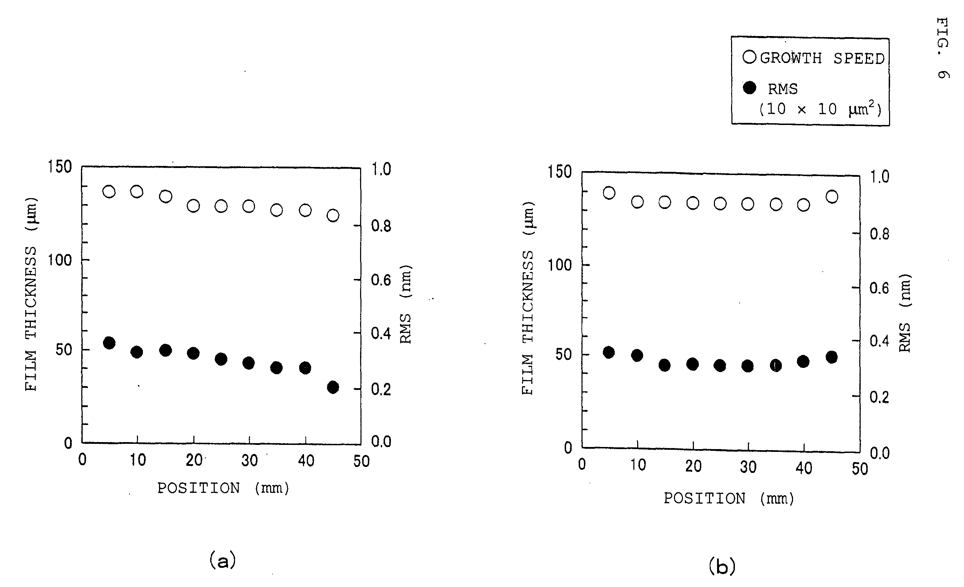

The growth speed at that time was 33 µm/h and an epitaxial layer such thick as substantially 130 µm was obtained after 4 hr's growth. A surface state of a thick silicon carbide epitaxial layer was a mirror surface and a high quality layer having no large surface defect could be formed. Furthermore, in Fig. 6, distributions of film thicknesses and surface roughnesses (a) in a parallel direction with a gas flow and (b) in an orthogonal direction to a gas flow of an epitaxial layer of silicon carbide are shown. When edge portion are excluded, excellent uniformity of σ/m of 2 to 4% was obtained. This is because, owing to the use of the susceptor as a heating source and the disposition of the insulating material, the temperature uniformity of the wafers was improved. The RMS in Fig. 6 means root mean square roughness and this is same in the following.

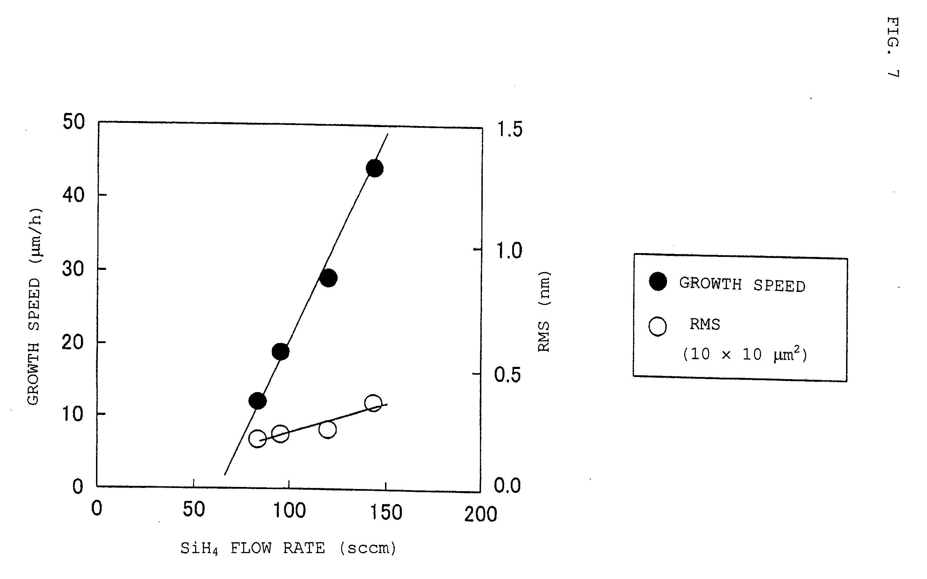

Furthermore, when the relationship between SiH₄ flow rate and growth speed under the growth condition of 1835°C was investigated, as shown in Fig. 7, the growth speed increased in proportion to the SiH₄ flow rate and a growth speed such high as 44 µm/h was obtained. This is because, since the susceptor was a heating source, a raw material gas contributing to a reaction in the neighborhood of a wafer was efficiently heated and decomposed. Even in the case of the growth speed of 44 µm/h where SiH₄ was much supplied, a smooth surface state of 0.3 nm was obtained. The RMS here was obtained of a range of 10 × 10 µm².

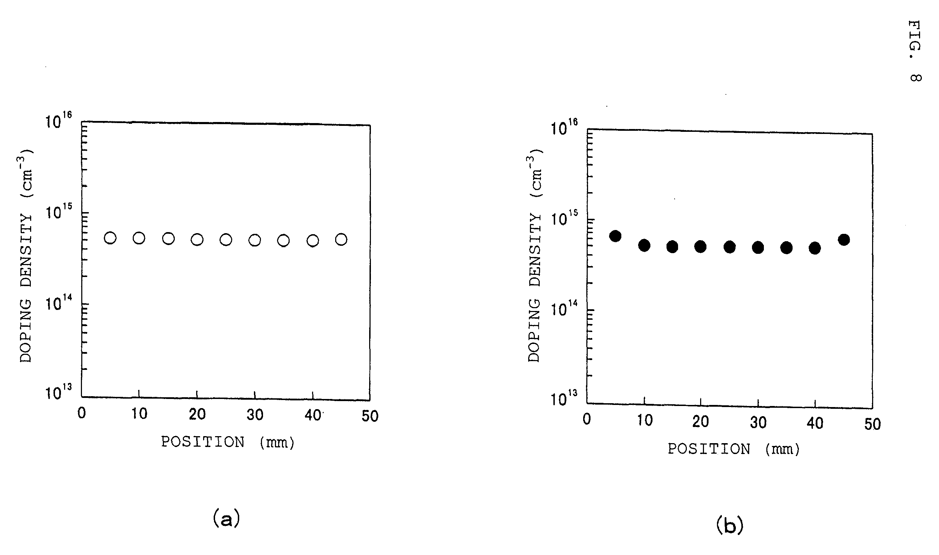

Furthermore, when a doping density distribution of the silicon carbide epitaxial layer was investigated, as shown in Fig. 8, both in a direction parallel with and a direction perpendicular to a gas flow, in a high purity region of 5 × 10¹⁴ cm⁻³, doping control was obtained. This is because a large improvement in the heating efficiency owing to efficient heating of the susceptor and wafer and disposition of the insulating material alleviates load of heating, and thereby the susceptor and the inner wall were inhibited from deteriorating. Furthermore, in the distribution of the doping density, excellent uniformity of 2 to 5% was obtained. This is because owing to the direct heating of the wafer with the susceptor as the heating source and the disposition of the insulating material, the uniformity of temperature in the wafer surface was improved.

The invention can be modified in the design within a range that does not deviate from a range of claims and is not restricted to the embodiments and examples.

### Brief Description of the Drawings

[Fig. 1] Fig. 1 includes perspective views separately showing constituent articles of a susceptor involving a first embodiment of the invention, (a) being a barrel type internal susceptor and (b) being an external member.
[Fig. 2] Fig. 2 is a schematic diagram showing the neighborhood of a reaction chamber of an epitaxial growth unit that uses the susceptor shown in Fig. 1.
[Fig. 3] Fig. 3 is a diagram showing a modification example of Fig. 2.
[Fig. 4] Fig. 4 includes perspective views separately showing constituent articles of a susceptor involving a second embodiment of the invention, (a) being an internal member and (b) being a barrel type external susceptor.

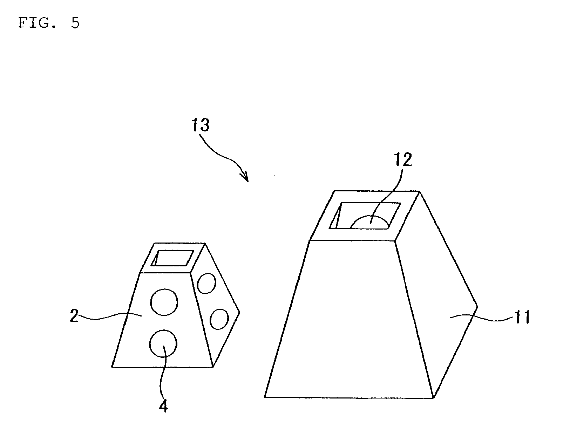

[Fig. 5] Fig. 5 is a diagram showing a modification example of the susceptor involving the first embodiment shown in Fig. 1 and the susceptor involving the second embodiment shown in Fig. 4.
[Fig. 6] Fig. 6 includes diagrams showing relationship between film thicknesses of epitaxial layers involving an example of the invention and distributions of surface roughnesses thereof, the relationship between film thicknesses of epitaxial layers and a distribution of surface roughnesses being shown in a direction parallel with a gas flow direction (a) and in a vertical direction to a gas flow direction (b).
[Fig. 7] Fig. 7 is a diagram showing SiH₄ flow rate dependency of growth speed of a film thickness of an epitaxial layer involving an example of the invention and the surface roughness thereof.
[Fig. 8] Fig. 8 includes diagrams showing a doping density distribution of an epitaxial layer involving an example of the invention, (a) showing the doping density distribution of the epitaxial layer in a parallel direction with a gas flow direction and (b) showing a doping density distribution of the epitaxial layer in an orthogonal direction to a gas flow direction.

### Description of the Reference Numerals and Signs

- 1, 9, 13:: susceptor
- 2:: internal susceptor
- 3:: external member
- 4:: counter boring portion
- 5:: reaction chamber
- 6:: heat insulating material
- 7:: high frequency coil
- 8:: substrate
- 10:: internal member
- 11:: external susceptor
- 12:: counter boring portion

## Claims

1. A susceptor that is used in semiconductor epitaxial growth, comprising:
a barrel type susceptor having a plurality of surfaces on an outer side of each of which a plurality of substrates is freely disposed; and a member that has the barrel type susceptor disposed inside thereof and surfaces each of which is oppositely disposed tilting in the same direction as each of the surfaces of the barrel type susceptor.

2. A susceptor that is used in semiconductor epitaxial growth, comprising:
a barrel type susceptor having a plurality of surfaces on an inner side of each of which a plurality of substrates is freely disposed; and a member that has the barrel type susceptor disposed at the peripheral portion thereof and surfaces each of which is oppositely disposed tilting in the same direction as each of the surfaces of the barrel type susceptor.

3. The susceptor according to claim 1 or 2, wherein each of surfaces on a side of the barrel type susceptor of the member allows placing a plurality of substrates.

4. The susceptor according to claim 1 or 2, wherein either one or both of the barrel type susceptor and the member are a heater.

5. The susceptor according to claim 1 or 2, wherein the susceptor is made of a base material containing graphite.

6. The susceptor according to claim 5, wherein the susceptor is covered with polycrystalline silicon carbide or polycrystalline tantalum carbide.
